# EUROPEAN PATENT APPLICATION

(11) **EP 3 416 186 A1**
(43) Date of publication of application: **19.12.2018**
(21) Application number: 17176032.5
(22) Date of filing: 14.06.2017
(51) Int. Cl.: H01L 23/367, H01L 23/488, H01L 21/60, H01L 23/373

(54) **SEMICONDUCTOR SUBSTRATE ARRANGEMENT WITH A CONNECTION LAYER WITH REGIONS OF DIFFERENT POROSITY AND METHOD FOR PRODUCING THE SAME**

(71) Applicant: Infineon Technologies AG, 85579 Neubiberg (DE)
(72) Inventor: Becker, Nico, 59581 Warstein (DE); Heuck, Nicolas, 33154 Salzkotten (DE); Otto, Frederik, 45659 Recklinghausen (DE)
(74) Representative: Westphal, Mussgnug & Partner Patentanwälte mbB

(57) **Abstract**

A semiconductor substrate (10) arrangement comprises an electrically insulating (dielectric) layer (11), a first metallization layer (111) on a first side of the electrically insulating layer (11) and a second metallization layer (112) on a second side of the electrically insulating layer (11), wherein the electrically insulating layer (11) is disposed between the first and the second metallization layer (111, 112). The semiconductor substrate (10) further comprises a connection layer (20) arranged on the first metallization layer (111) and/or on the second metallization layer (112), wherein the connection layer (20) comprises a plurality of first regions (a) having a first porosity and a plurality of second regions (b) having a second porosity, and wherein the first porosity is different from the second porosity. The first regions (a) may alternate with the second regions (b) in at least one horizontal direction of the semiconductor substrate (10). The manufacturing method comprises applying a pre-layer (21) having a wavy profile to a first surface or to a second surface of a semiconductor substrate (10) as above and mounting a component (30, 31) to the pre-layer (21) by applying pressure to the component (30, 31) and the pre-layer (21), thereby levelling the pre-layer (21) such that an essentially plane connection layer (20) with the regions (a, b) of different porosity is formed. The pre-layer (21) may be applied to the surface of the semiconductor substrate (10) by screen printing. Alternatively, a paste (22) may be applied on a foil (70) in desired regions only and then transferred to the surface of the semiconductor substrate (10). The component (30) may be a semiconductor body and the component (31) may be a base plate or a heat sink.

The regions (b) of higher porosity may form buffer regions for the regions of low porosity (a) and thus reduce the formation of cracks (40) occurring during thermal cycling.

## Description

### TECHNICAL FIELD

The instant disclosure relates to a semiconductor substrate arrangement, in particular a semiconductor substrate arrangement for a power semiconductor module arrangement, and a method for producing the same.

### BACKGROUND

Power semiconductor module arrangements often include a base plate within a housing. At least one substrate is arranged on the base plate. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer is usually attached to the base plate. When mounting the controllable semiconductor elements to the substrate, e.g., by sintering, a connection layer is applied between the semiconductor substrate and the semiconductor elements.

During operation of the semiconductor module, the semiconductor elements produce heat. The connection layer between the semiconductor elements and the substrate dissipates heat away from the semiconductor elements to the substrate. However, the connection layer deforms when heated. Usually, temperatures are greater at the center of a semiconductor element, while temperatures are lower near the edges of a semiconductor element. Therefore, the connection layer may be heated unevenly. Over the lifetime of a semiconductor module, a great number of heating and cooling cycles are performed. This may drastically reduce the lifetime of the semiconductor module, because the connection layer may be corrupted over time and the function of the semiconductor elements may not be guaranteed anymore.

There is a need for a semiconductor substrate arrangement having a longer lifetime, and for a method for producing the same.

### SUMMARY

A semiconductor substrate includes an electrically insulating layer, a first metallization layer on a first side of the electrically insulating layer, and a second metallization layer on a second side of the electrically insulating layer, wherein the dielectric insulation layer is disposed between the first and the second metallization layer. The semiconductor substrate further includes a connection layer arranged on the first metallization layer, wherein the connection layer comprises a plurality of first regions having a first porosity and a plurality of second regions having a second porosity, and wherein the first porosity is different from the second porosity.

A method includes applying a pre-layer having a wavy profile to a first surface of a semiconductor substrate, wherein the semiconductor substrate comprises an electrically insulating layer, a first metallization layer on a first side of the electrically insulating layer, and a second metallization layer on a second side of the electrically insulating layer, wherein the dielectric insulation layer is disposed between the first and the second metallization layer. The method further comprises mounting a semiconductor body to the pre-layer, wherein mounting the semiconductor body to the pre-layer comprises applying pressure to the semiconductor body and the pre-layer, thereby leveling the pre-layer such that an essentially plane connection layer is formed between the semiconductor substrate and the semiconductor body. The connection layer comprises a plurality of first regions having a first porosity and a plurality of second regions having a second porosity, wherein the first porosity is different from the second porosity.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1, including Figures 1A to 1C, illustrates cross-sectional views of a semiconductor substrate.
Figure 2, including Figures 2A and 2B, illustrates cross-sectional views of a semiconductor substrate in an idle state and in operation.
Figure 3 schematically illustrates a cross-sectional view of a semiconductor substrate.
Figure 4 schematically illustrates in a cross-sectional view an example of a semiconductor substrate with a semiconductor body mounted thereon.
Figure 5, including Figures 5A and 5B, schematically illustrates top views of exemplary semiconductor substrates.
Figure 6, including Figures 6A to 6C, schematically illustrates an example of a method for producing a semiconductor substrate.
Figure 7, including Figures 7A and 7B, schematically illustrates a further example of a method for producing a semiconductor substrate.
Figure 8, including Figures 8A and 8B, schematically illustrates different manufacturing steps of the semiconductor substrate.
Figure 9 schematically illustrates an example of a semiconductor substrate arrangement.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

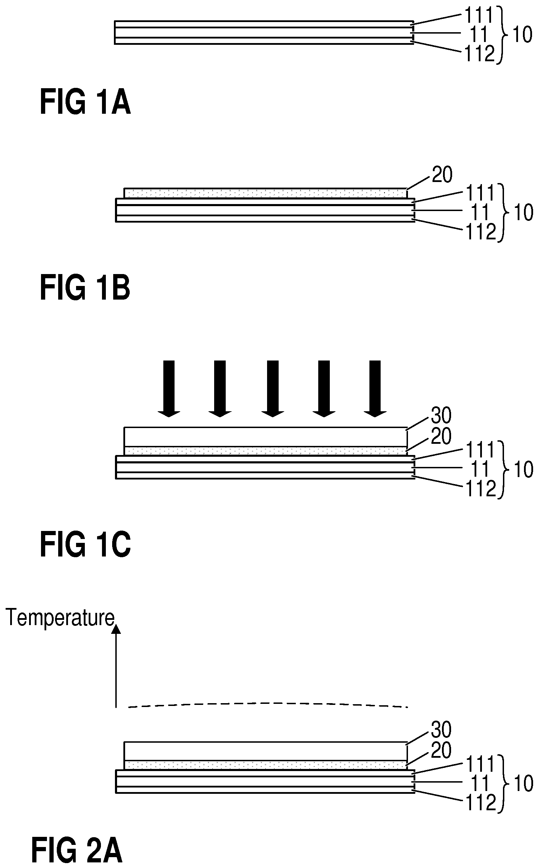

Referring to Figure 1A, a semiconductor substrate 10 is illustrated. The semiconductor substrate 10 includes a dielectric insulation layer (11), a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminium; an aluminium alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminium oxide; aluminium nitride; zirconium oxide; silicon nitride; boron nitride; or any other dielectric ceramic. For example, the dielectric insulation layer 11 may consist of or include one of the following materials: Al₂O₃, AlN, or Si₃N₄. For instance, the substrate 10 may, e.g., be a Direct Copper Bonding (DCB) substrate, a Direct Aluminium Bonding (DAB) substrate, or an Active Metal Brazing (AMB) substrate. The substrate 10 may also be a conventional printed circuit board (PCB) having a non-ceramic dielectric insulation layer 11. For instance, a non-ceramic dielectric insulation layer 11 may consist of or include a cured resin.

Referring to Figure 1C, one or more semiconductor bodies 30 may be arranged on the semiconductor substrate 10. Each of the semiconductor bodies 30 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element. The one or more semiconductor bodies 30 may form a semiconductor arrangement on the semiconductor substrate 10. In Figure 1C, only one semiconductor body 30 is exemplarily illustrated.

The first metallization layer 111 of Figure 1 is a continuous layer. The first metallization layer 111, however, may be structured, for example if more than one semiconductor body 30 is mounted to the semiconductor substrate 10. "Structured metallization layer" means that the first metallization layer 111 is not a continuous layer, but includes recesses between different sections of the layer. Different semiconductor bodies 30 may be mounted to the same or to different sections of the first metallization layer 111. The different sections may have no electrical connection or may be electrically connected using, e.g., bonding wires. Each of the one or more semiconductor bodies 30 may be electrically and mechanically connected to the semiconductor substrate 10 by an electrically conductive connection layer 20. Figure 1B exemplarily illustrates a semiconductor substrate 10 with a connection layer 20 arranged thereon. The electrically conductive connection layer 20 generally may be a solder layer, a layer of an electrically conductive adhesive, or a layer of a sintered metal powder, e.g., a sintered silver powder.

When mounting the semiconductor bodies 30 to the substrate 10, the semiconductor bodies 30 are arranged on the substrate surface (top surface) with the connection layer 20 arranged in between, and are pressed onto the substrate 10. This is illustrated by means of the bold arrows in Figure 1C. The top surface of the semiconductor substrate 10 is a surface of the first metallization layer 111 which faces away from the dielectric insulation layer 11. The substrate 10, the semiconductor bodies 30 as well as the connection layer 20 between the substrate 10 and the semiconductor bodies 30 may be heated during the mounting process (while applying pressure to the semiconductor bodies 30), which may be a sintering process, for example. The temperature during the mounting of the semiconductor bodies 30 may be more than 200 °C, more than 300 °C, or more than 400 °C, for example. The semiconductor bodies 30 are then permanently attached to the semiconductor substrate 10, and the connection layer 20 provides a stable, substance-to-substance bond between the semiconductor bodies 30 and the semiconductor substrate 10.

When applying pressure to the semiconductor bodies 30 and, thereby, the connection layer 20, the connection layer 20 is compacted. After the mounting process, the connection layer 20, therefore, has a certain compaction (porosity). A low porosity (high compaction) generally provides a high mechanical strength and a good thermal and electric conductivity. A high porosity (low compaction), on the other hand, results in a low stiffness of the connection layer 20 and, therefore, low mechanical stresses in the structure including the semiconductor body 30, the semiconductor substrate 10 and the connection layer 20.

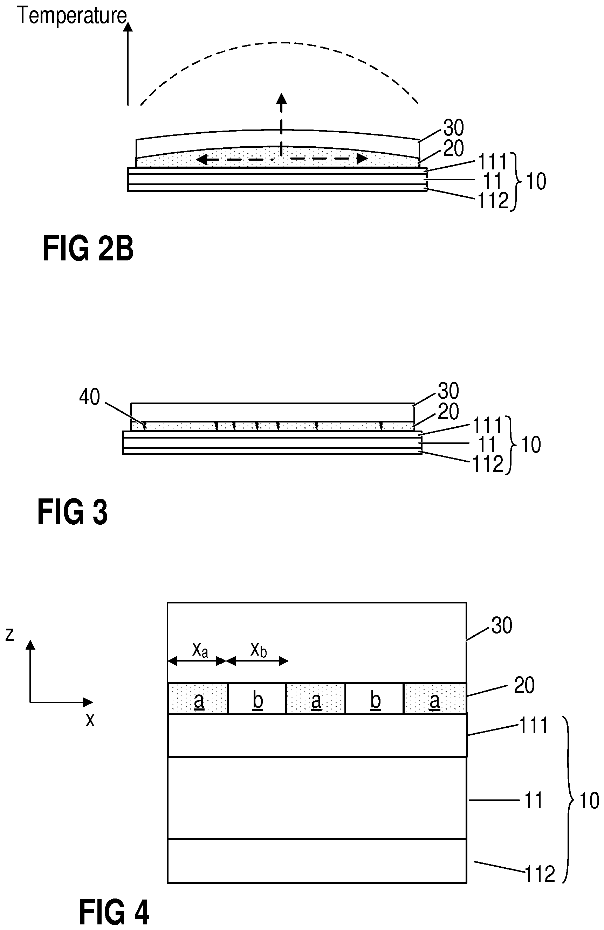

During the operation of the semiconductor arrangement with the one or more semiconductor bodies 30, the semiconductor bodies 30 produce heat. In particular, a flow of a (load) current I_{L} through the semiconductor body 30 results in a heating of the semiconductor body 30 (conduction and power losses). While the semiconductor body 30 is switched off, as well as during a time interval shortly after switching on the semiconductor body, the temperature distribution over the semiconductor body 30 is essentially even, as is schematically illustrated in Figure 2A. During the operation of the semiconductor body 30, however, the temperature at the center of the semiconductor body 30 is usually higher than in the edge regions, as is schematically illustrated in Figure 2B. The temperature distribution is generally dependent on the duration of the current flow through the semiconductor body 30. In general, the temperatures are higher, the longer the duration of the current flow.

When heated, the connection layer 20, which may be a sintered connection layer, expands to a certain amount. As the temperatures at and below the center of the semiconductor body 30 are higher than the temperature at the edges of the semiconductor body 30, the connection layer 20 expands more in areas below the center of the semiconductor body 30. The expansion of the connection layer 20 is schematically illustrated in Figure 2B and further emphasized by the dashed arrows. The thermomechanical stress on the connection layer 20, therefore, is usually rather high. A sintered connection layer 20 may have an expansion coefficient of CTE_{Ag} ∼ 19 ppm/K, for example. The expansion coefficient of a (sintered) connection layer 20 usually is considerably higher than the expansion coefficient of the semiconductor body 30 and of the semiconductor substrate 10. For example, the expansion coefficient of the semiconductor body 30 may be CTE_{Chip} ∼ 4 ppm/k, and the expansion coefficient of the semiconductor substrate 10 may be between CTE_{Substrate} ∼ 5 ppm/K and CTE_{Substrate} ∼ 8 ppm/K. The given values are, however, only example. Other values are also possible.

Over the lifetime of the power semiconductor arrangement, the semiconductor bodies 30 are heated and cooled many times. The cyclic heating and cooling of the semiconductor bodies 30 and of the connection layer 20 results in a mechanical fatigue of the connection layer 20, in particular a mechanical fatigue originating from the area below the center of the semiconductor body 30. Referring to Figure 3, a commencing fatigue of the connection layer 20 is schematically illustrated. The mechanical fatigue may result in vertical cracks or ruptures 40, as exemplarily illustrated in Figure 3. Such cracks or ruptures 40 may severely limit the thermal and electrical conductivity of the connection layer 20 which may, eventually, result in a failure of the semiconductor body 30 and the whole power semiconductor arrangement.

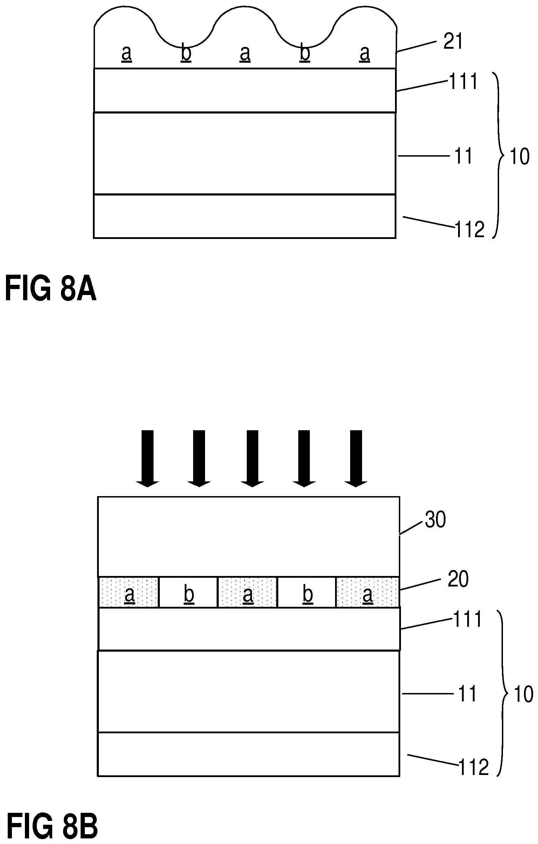

Figure 4 schematically illustrates a semiconductor substrate 10 with a connection layer 20 arranged thereon. The connection layer 20 comprises first regions (a) and second regions (b). The first regions (a) each have a first porosity and the second regions (b) each have a second porosity. The first porosity is different from the second porosity. For example, the first porosity may be lower than the second porosity. The porosity of a material generally is a measure of the void (e.g., "empty") spaces in the material, and is a fraction of the volume of voids over the total volume, between 0 and 1. The porosity may also be given as a percentage between 0 and 100%. The porosity of the first regions (a) may be, for example about 10% or lower, about 15% or lower or about 20% or lower. The porosity of the second regions (b) may be more than 10%, more than 20%, more than 40% or more than 50%, for example. In other words, the first regions (a) may be more compacted than the second regions (b) as will be described referring to Figure 8 below.

Generally, the porosity of a region may be subject to fluctuations. For example, the porosity near the edges of a region may be higher than further away from the edges, or vice versa. Such differences in porosity within one and the same region, however, are comparably marginal. For example, within one region the porosity may have deviations of about ±1%, ±3% or ±5% from an average value. The average value of the porosity of the first regions (a) may be more than 5%, more than 10%, more than 15% or more than 20% lower than the average value of the porosity of the second regions (b), for example. For example, if the first regions (a) have an average porosity of 10%, the porosity near the edges of the first regions (a) may be 12%, while the porosity further away from the edges may be 8% (10% ± 2%). The average porosity of the second regions (b) in this example may be 15%, for example, which is 5% higher than the average porosity of the first regions (a). The difference between the porosity of the first regions (a) and the porosity of the second regions (b), therefore, is higher than the normal variations.

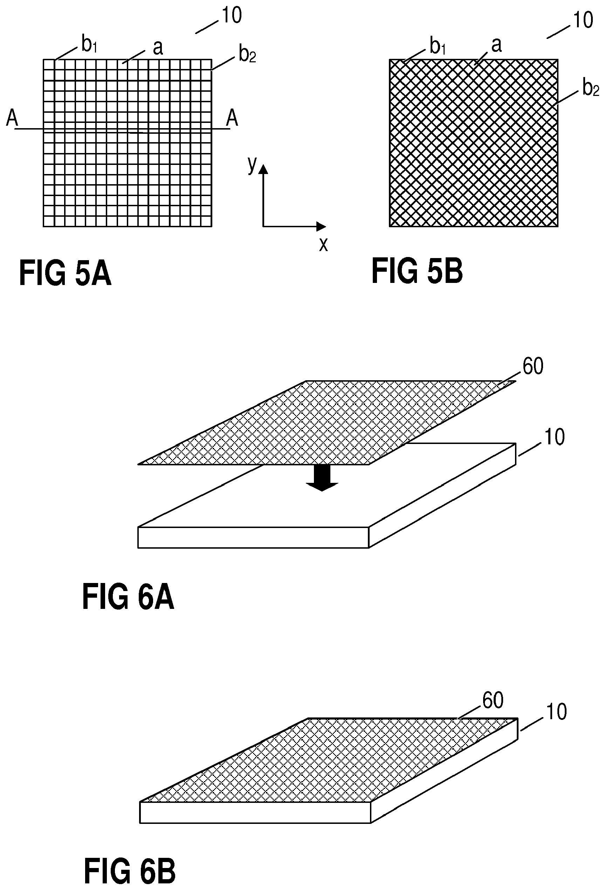

Figure 4 illustrates a cross-sectional view of a section of a semiconductor substrate 10 with a connection layer 20 and a semiconductor body 30. As can be seen, first regions (a) alternate with second regions (b). The alternating first regions (a) and second regions (b) may form a periodic pattern. Each first region (a) may have a first width xₐ in a first horizontal direction x of the connection layer 20. Each second region (b) may have a second width x_{b} in the first horizontal direction x of the connection layer 20. The first horizontal direction x may be a direction that is parallel to the top surface of the semiconductor substrate 10 on which the connection layer 20 is arranged. The first horizontal direction x may be parallel to the x-axis of a coordinate system as schematically illustrated in Figure 4. The first regions (a) may each have a first length and the second regions (b) may each have a second length in a second horizontal direction y. The second horizontal direction y is parallel to the top surface of the semiconductor substrate 10 on which the connection layer 20 is arranged, and perpendicular to the first horizontal direction. Figure 5A illustrates a top view of a semiconductor substrate 10. The second horizontal direction y may be parallel to the z-axis of a coordinate system as schematically illustrated in Figure 5A. The length of a region (a), (b) in the second horizontal direction y may be the same or may be different from the width of the same region (a), (b) in the first horizontal direction x. A vertical direction may be defined as a direction that is perpendicular to the top surface of the semiconductor substrate 10. The vertical direction z is perpendicular to both the first horizontal direction x and the second horizontal direction y. The vertical direction z may be parallel to the z-axis of a coordinate system as schematically illustrated in Figure 4. The arrangement in Figure 4 exemplarily illustrates a section of the cross-section of a semiconductor substrate 10, e.g., in a section plane A-A of the arrangement illustrated in Figure 5A.

Referring to Figure 5A, which illustrates a top view of an exemplary semiconductor substrate 10, the first regions (a) and the second regions (b) of the connection layer 20 may form a grid pattern. In other words, the first regions (a) may be quadratic or rectangular, when seen from above and the second regions (b) may form a grid which separates the individual first regions (a) from one another. In other words, the second regions (b) may be thin, elongated regions that separate the individual first regions (a) from one another. A first number of second regions (b₁) may be elongated in the first horizontal direction (x) such that their width is considerably larger than their length. For example, the width of each of the first number of second regions (b₁) may be more than 10 times larger, more than 100 times larger, or more than 1.000 times larger than their respective length. A second number of the second regions (b₂) may be arranged perpendicular to the first number of second regions (b₁) and may be elongated in the second horizontal direction (y) such that their length is considerably larger than their width. For example, the length of each of the second number of second regions (b₂) may be more than 10 times larger, more than 100 times larger, or more than 1.000 times larger than their width. The width x_{b} of a second region (b) of the first number of second regions (b₁), as illustrated in Figure 4, may be between 20µm and 500µm, for example. The width xₐ and the length of a first region (a) as illustrated in Figure 4, may also be between 20µm and 500µm, for example. The width of the first regions (a) may be different from the width of the second regions (b) of the first number of second regions (b₁). While the individual first regions (a) are separated from each other, the second regions (b) may each intersect with at least one other second region (b).

According to another example, which is exemplarily illustrated in Figure 5B, the first regions (a) may be diamond shaped. The second regions (b) may form a grid which separates the individual first regions (a) from one another. As can be seen in the example in Figure 5B, the first number of second regions (b₁) does not necessarily have to run parallel to the first horizontal direction (x) as in the example of Figure 5A. The same applies for the second number of second regions (b₂) and the second horizontal direction (y), respectively. An angle at an intersection between a second region of the first number of second regions (b₁) and a second region of the second number of second regions (b₂) may be 90° or may be an angle smaller or greater than 90°.

The patterns that are illustrated in Figures 5A and 5B, however, are only examples. Any pattern may be used that provides alternating first regions (a) and second regions (b) in at least one horizontal direction. In the examples of Figure 5, first regions (a) alternate with second regions (b) in more than one direction, e.g., in the first horizontal direction (x) as well as in the second horizontal direction (y). However, it is generally possible, that the first regions (a) are also thin, elongated regions and the first regions (a) alternate with the second regions (b) only in one horizontal direction, e.g., the first horizontal direction (x). In other words, in the direction of the resulting tensile stress and compressive stress during the operation of the semiconductor body 30, regions of high solidity and high rigidity (region of low porosity (a)) alternate with regions of higher flexibility and lower solidity (region of high porosity (b)). This reduces mechanical stresses at least in one direction x, y of the connection layer 20. The regions of lower porosity may "breathe" into the neighboring regions of higher porosity during the heating/cooling-cycle. The regions of higher porosity, therefore, may form buffer regions for the regions of low porosity which may reduce the formation of cracks 40 (see Figure 3).

The number of first regions (a) and second regions (b) generally depends on the dimensions of the connection layer 20 in the first horizontal direction x and in the second horizontal direction y. Generally, the connection layer 20 comprises more than 1, more than 10, more than 50 or more than 100 first regions (a) and more than 1, more than 10, more than 50 or more than 100 second regions (b). The number of first regions (a) may be different from the number of second regions (b) or may equal the number of second regions (b).

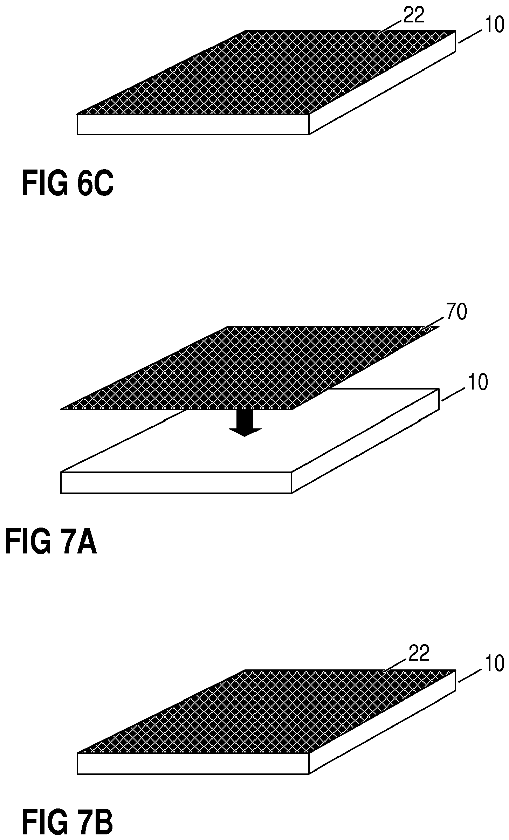

A method for producing a semiconductor substrate 10 with a connection layer 20 having alternating first and second regions (a, b) and, therefore, an alternating porosity, comprises applying a pre-layer 21 to a first surface of the semiconductor substrate 10 (see Figure 8A). The first surface of the semiconductor substrate 10 may be a top surface of the first metallization layer 111 opposite to a second surface of the first metallization layer 20, the second surface contacting the dielectric insulation layer 11 and the first surface facing away from the dielectric insulation layer 11. Before applying the pre-layer 21, a grid, screen, template, sieve 60, or anything similar, (hereinafter referred to as screen) may be arranged on the semiconductor substrate 10, as is schematically illustrated in Figures 6A and 6B. The screen 60 covers some parts of the first surface of the semiconductor substrate 10, while other parts of the first surface remain free (uncovered). A paste 22 may be applied to the first surface with the screen 60 arranged thereon. The paste 22, therefore, only covers those parts of the first surface that are not covered by the screen 60, while the screen 60 is still arranged on the semiconductor substrate 10, as is schematically illustrated in Figure 6C. The paste 22 reproduces a negative of the screen 60.

According to one example, the screen 60 comprises a frame with a plurality of thin wires or bars arranged within the frame to cover certain areas of the semiconductor substrate 10. The width of such wires or bars may correspond to the desired width of the second regions (b), for example. However, the width of the wires or bars may also be different from the desired width of the second regions (b). For example, the wires or bars may be slightly wider than the desired width of the second regions (b). This is because a paste 22 that is applied to the semiconductor substrate 10 runs after removing the screen 60. Therefore, the pattern is slightly blurred once the screen 60 has been removed from the semiconductor substrate 10. Therefore, the width of the wires or bars may depend on the composition of the paste 22, especially on how viscous and/or thixotropic it is and on how much it runs after applying it to the semiconductor substrate 10. According to another example, the screen 60 comprises a (metal) template.

The paste 22 may comprise an organic substance such as terpineol or alcohol, for example. Generally, the paste 22 may comprise any suitable agent. Particles, such as metal particles, for example, may be dispersed in the organic substance. The metal particles may include at least one of Ag, Cu, and Au, for example. The metal particles may have an average diameter of less than 30µm, less than 10µm, less than 5µm, less than 1µm, or less than 0.5 µm, for example. The metal particles may have an average diameter of at least 0.1µm, at least 0.5µm, at least 1µm, at least 2µm, or at least 5µm, for example. The paste 22 may be liquid, viscous or wax-like, for example. The paste 22 may be applied with a thickness in the first vertical direction (z) of between 1µm and 100µm, for example.

After applying the paste 22, the screen 60 may be removed from the semiconductor substrate 10. As the paste 22 is liquid, viscous or wax-like, it runs and may subsequently also cover those parts of the semiconductor substrate 10 that were previously covered by the screen 60. However, the thickness of the paste 22 in the regions that were previously covered by the screen 60 may be less than the thickness in those regions that were not covered by the screen 60, as is exemplarily illustrated in Figure 8A. The thicker sections of the paste 22 may later form the first regions (a) and the thinner sections of the paste 22 may later form the second regions (b). After removing the screen 60, the paste 22 may have a corrugated or wavy profile (surface).

According to another example, the paste 22 may be liquid, viscous or wax-like and may stick to the screen 60 when the screen 60 is removed from the semiconductor substrate. Therefore, it is also possible that when removing the screen 60, the paste 22 is hauled upwards by the screen 60. This results in the opposite effect, namely the thickness of the paste 22 in the regions that were previously covered by the screen 60 being greater than the thickness in those regions that were not covered by the screen 60. Whether the paste 22 sticks to the screen 60 or not, essentially depends on the composition, the consistency and the rheological properties of the paste 22.

A drying step may follow to form the pre-layer 21. While drying the paste 22, some or all of the liquid of the paste 22 may be evaporated. The drying step may comprise heating the pre-layer 21. After the drying step, the resulting pre-layer 21, therefore, is no longer liquid, viscous or wax-like. After the drying step, the pre-layer 21 is hardened and also has a corrugated or wavy profile, as is illustrated in Figure 8A.

Using a screen 60 to form a pre-layer 21 with a corrugated or wavy profile as is exemplarily illustrated in Figure 6, however, is only an example. The paste 22 may be applied to the semiconductor substrate 10 in any other suitable way. One further possibility is exemplarily illustrated in Figure 7. Figure 7A schematically illustrates a semiconductor substrate 10 and a foil 70. The paste 22 is applied to the foil 70, in particular to a bottom surface of the foil 70. The paste 22 may be applied to the foil 70 in desired regions only. For example, the paste may be applied to the foil 70 in a certain pattern, which resembles the pattern of the desired first regions (a) and second regions (b). The foil 70 is then placed on the semiconductor substrate 10, its bottom surface facing the semiconductor substrate 10. In this way, the paste 22 may be applied to the semiconductor substrate 10. In particular, the paste 22 may stick to the semiconductor substrate 10 even after subsequently removing the foil 70, as is illustrated in Figure 7B. The paste 22, as has been explained before with respect to Figure 6, may be liquid, viscous or wax-like, for example. As the paste 22 is liquid, viscous or wax-like, it runs and may subsequently also cover those parts of the semiconductor substrate 10 that were previously not covered by the paste 22 on the foil 70. Therefore, after removing the foil 70 from the semiconductor substrate 10, the paste 22 remaining on the semiconductor substrate 10 may have a corrugated or wavy profile. The paste may subsequently be dried, as has been described before, resulting in a pre-layer 21 having a corrugated or wavy profile.

According to another example, a drying step may be performed after applying the paste 22 to the foil 70. In this example, the paste 22 is hardened before applying it to the semiconductor substrate 10 and is no longer liquid, viscous or wax-like when placing the foil 70 on the semiconductor substrate 10. The paste 22 may be applied to the foil using screen printing, stencil printing, inkjet printing, or spray-on techniques, for example. The foil 70 with the dried paste 22 thereon may be pressed to the semiconductor substrate 10 with low pressure to transfer the paste 22 from the foil 70 to the semiconductor substrate. The paste 22 has a corrugated or wavy profile on the foil 70. This corrugated or wavy profile is transferred to the semiconductor substrate 10 when pressing the foil 70 to the semiconductor substrate. In this case, no further drying step is required after applying the paste 22 to the semiconductor substrate 10 to form the pre-layer 21.

The pre-layer 21, therefore, has different thicknesses in different regions, as is schematically illustrated in Figure 8A. The regions having a greater thickness may later form the first regions (a), for example, while the regions having a smaller thickness may later for the second regions (b), or vice versa. In a following step, a semiconductor body 30 is mounted to the semiconductor substrate 10. During this mounting step, the semiconductor body is arranged on the pre-layer 21 and is subsequently pressed to the pre-layer 21 with a certain force. This is schematically illustrated in Figure 8B. Heat may be applied in addition to applying a force to the semiconductor body 30. Applying heat, however, is optional. The semiconductor body 30 may be mounted to the semiconductor substrate 10 at room temperature, at a temperature of up to 200 °C, up to 300 °C, up to 400 °C, or up to 500 °C, for example.

When applying a force or pressure to the semiconductor body 30, the corrugated or wavy pre-layer 21 is levelled, resulting in an essentially plane connection layer 20. The pressure that is applied to the regions of the pre-layer 21 having a greater thickness is higher than the pressure that is applied to those regions of the pre-layer 21 having a smaller thickness. The regions of the pre-layer 21 having a greater thickness, therefore, are compressed more than those regions of the pre-layer 21 having a smaller thickness. A higher compression leads to a lower porosity. The first regions (a) in the example of Figure 8A, therefore, are compressed more and have a lower porosity than the second regions (b). The connection layer 20 may have a thickness of between 1 µm and 80 µm, for example.

As is schematically illustrated in Figure 8A, the thickness of the pre-layer 21 may vary even within one region. Therefore, the pressure that is applied to the pre-layer 21 varies even within one region. For example, as is illustrated in Figure 8A, the regions later forming the first regions (a) are thicker at their center and have a lower thickness near the edges which adjoin the second regions (b). Therefore, the first regions (a) are compressed more in their center and less at the edges, resulting in a varying porosity, as has already been described above. The transition between the first regions (a) and the second regions (b), therefore, is usually a fluent transition.

A method for producing a semiconductor substrate 10, therefore, comprises forming a pre-layer 21 on the semiconductor substrate 10. The pre-layer 21 may have a varying thickness (wavy profile) and may be applied by any suitable process such as stencil printing, screen printing, inkjet printing, spray-on techniques, or foil printing, for example. The areas of a greater thickness may essentially correspond to the first regions (a) and the areas of a smaller thickness may essentially correspond to the second regions (b). The areas of greater thickness and the areas of a smaller thickness, therefore, may form a pattern that essentially corresponds to the pattern of the first and second regions (a, b). The pre-layer 21 may be hardened during a following drying step. In a further step, the corrugated or wavy profile of the hardened pre-layer 21 may be levelled, thereby compressing areas with a greater thickness more than areas with a smaller thickness, resulting in an essentially plane connection layer 20. The connection layer 20 comprises first regions (a) having a first porosity, and second regions (b) having a second porosity which is different from the first porosity.

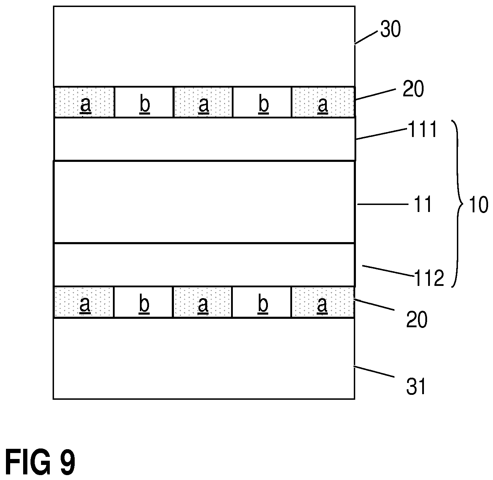

A connection layer 20 may be arranged on a first side of the semiconductor substrate 10, between the semiconductor substrate 10 and a semiconductor body 30, as has been explained above. This, however, is only an example. Often, semiconductor substrates 10 are mounted to a base plate or a heat sink 31, for example. For example, the semiconductor substrate 10 may be mounted to a base plate 31 such that the second metallization layer 112 is arranged between the semiconductor substrate 10 and the base plate 31. A connection layer 20 may be arranged between the second metallization layer 112 and the base plate 31, as is exemplarily illustrated in Figure 9. The connection layer 20 arranged between the semiconductor substrate 10 and a base plate 31 may have the same features and characteristics as has been described before with reference to Figures 4 to 8. Further, the connection layer 20 arranged between the semiconductor substrate 10 and a base plate 31 may be produced in the same way as has been described before with reference to Figures 4 to 8.

According to one example of a semiconductor substrate arrangement, a connection layer 20 is arranged on a first side of the semiconductor substrate 10 between the semiconductor substrate 10 and a semiconductor body. According to another example of a semiconductor substrate arrangement, a connection layer 20 is arranged on a second side of the semiconductor substrate 10 between the semiconductor substrate 10 and a base plate 31. According to an even further example, a connection layer 20 is arranged on a first side of the semiconductor substrate 10 between the semiconductor substrate 10 and a semiconductor body and a further connection layer 20 is arranged on a second side of the semiconductor substrate 10 between the semiconductor substrate 10 and a base plate 31. Generally speaking, a connection layer 20 may be arranged on one side of the semiconductor substrate 10 only or on both sides of the semiconductor substrate 10. The connection layer 20 as described above may be used for mounting any component to the semiconductor substrate. Instead of a semiconductor body 30, a base plate 31 or any other component may be pressed to the corrugated or wavy pre-layer 21, resulting in an essentially plane connection layer 20.

Depending on the size of the component, the connection layer 20 may cover only parts of or all of the respective surface. For example, if a semiconductor body 30 is mounted to the semiconductor substrate 10 with a connection layer 20, the connection layer 20 may only partly cover the first metallization layer 111, namely such regions that are arranged below the semiconductor body 30. If a base plate 31 is mounted to the semiconductor substrate 10 with a connection layer 20, the connection layer may completely cover the second metallization layer 112. This is because the base plate 31 is usually greater in size than the semiconductor substrate 10.

## Claims

1. A semiconductor substrate (10) arrangement comprising:
an electrically insulating layer (11), a first metallization layer (111) on a first side of the electrically insulating layer (111), and a second metallization layer (112) on a second side of the electrically insulating layer (11), wherein the dielectric insulation layer (11) is disposed between the first and the second metallization layer (111, 112); and
a connection layer (20) arranged on the first metallization layer (111) or on the second metallization layer (112),
wherein the connection layer (20) comprises a plurality of first regions (a) having a first porosity and a plurality of second regions (b) having a second porosity, and
wherein the first porosity is different from the second porosity.

2. The semiconductor substrate (10) arrangement of claim 1, wherein the first regions (a) alternate with the second regions (b) in at least one horizontal direction of the semiconductor substrate (10), wherein a horizontal direction of the semiconductor substrate (10) is a direction parallel to a top surface of the semiconductor substrate (10).

3. The semiconductor substrate (10) arrangement of claim 2, wherein the alternating first and second regions (a, b) form a periodic pattern.

4. The semiconductor substrate (10) arrangement of claim 3, wherein the periodic pattern is a grid pattern.

5. The semiconductor substrate (10) arrangement of any of the preceding claims,
wherein
each first region (a) has a first width (xₐ) in a first horizontal direction (x) of the connection layer (20); and
each second region (b) has a second width (x_{b}) in the first horizontal direction (x) of the connection layer (20).

6. The semiconductor substrate (10) arrangement of claim 5, wherein at least one of
the first width (xₐ) is between 20µm and 500µm; and
the second width (x_{b}) is between 20µm and 500µm.

7. The semiconductor substrate (10) arrangement of any of the preceding claims, wherein at least one of
the first regions (a) have a first porosity of 20% or lower, 15% or lower, or 10% or lower;
the second regions (b) have a second porosity of more than 10%, more than 20%, more than 40% or more than 50%; and
the porosity of the first regions (a) is more than 5%, more than 10%, more than 15%, or more than 20% lower than the porosity of the second regions (b).

8. The semiconductor substrate (10) arrangement of any of the preceding claims,
wherein the connection layer (20) has a thickness of between 1 µm and 80 µm.

9. The semiconductor substrate (10) arrangement of any of the preceding claims,
wherein each of the plurality of first regions (a) has a square shape, a rectangular shape, or a diamond shape.

10. The semiconductor substrate (10) arrangement of any of the preceding claims,
wherein
each of the plurality of second regions (b) is an elongated region; and
the plurality of second regions (b) are configured to separate the individual first regions (a) from one another.

11. The semiconductor substrate (10) arrangement of claim 10, wherein
the length of each of a first number (b₁) of second regions (b) is 10 times, 100 times or 1.000 times larger than the width (x_{b}) of the respective second region (b₁), and
the width (x_{b}) of each of a second number (b₂) of second regions (b) is 10 times, 100 times or 1.000 times larger than the length of the respective second region (b₂).

12. A method comprising:
applying a pre-layer (21) having a wavy profile to a first surface or to a second surface of a semiconductor substrate (10), wherein the semiconductor substrate (10) comprises an electrically insulating layer (11), a first metallization layer (111) on a first side of the electrically insulating layer (111), and a second metallization layer (112) on a second side of the electrically insulating layer (11), wherein the dielectric insulation layer (11) is disposed between the first and the second metallization layer (111, 112); and
mounting a component (30, 31) to the pre-layer (21),
wherein mounting the component (30, 31) to the pre-layer (21) comprises applying
pressure to the component (30, 31) and the pre-layer (21), thereby leveling the pre-layer (21) such that an essentially plane connection layer (20) is formed between the semiconductor substrate (10) and the component (30, 31),
wherein the connection layer (20) comprises a plurality of first regions (a) having a first porosity and a plurality of second regions (b) having a second porosity, and
wherein the first porosity is different from the second porosity.

13. The method of claim 12, wherein applying a pre-layer (21) to the first surface of the semiconductor substrate (10) comprises applying a liquid, viscous or wax-like paste (22) to the first surface of the semiconductor substrate (10).

14. The method of claim 13, wherein applying a pre-layer (21) to the first surface of the semiconductor substrate (10) further comprises
covering some parts of the first surface with a screen (60) and leaving other parts of the first surface uncovered; and
applying the paste (22) to those parts of the first surface which remain uncovered.

15. The method of claim 14, further comprising:
removing the screen (60) from the first surface; and
performing a drying step to remove liquid from the paste (22).

## Amended claims

### Amended claims in accordance with Rule 137(2) EPC.

1. A semiconductor substrate (10) arrangement comprising:
an electrically insulating layer (11), a first metallization layer (111) on a first side of the electrically insulating layer (111), and a second metallization layer (112) on a second side of the electrically insulating layer (11), wherein the electrically insulating layer (11) is disposed between the first and the second metallization layer (111, 112);
a plane connection layer (20) arranged on the first metallization layer (111) or on the second metallization layer (112); and
a component (30, 31) arranged on the connection layer (20),
wherein the connection layer (20) comprises a plurality of first regions (a) having a first porosity and a plurality of second regions (b) having a second porosity,
wherein the first porosity is different from the second porosity,
wherein each first region (a) has a first width (xₐ) in a first horizontal direction (x) of the connection layer (20), and each second region (b) has a second width (x_{b}) in the first horizontal direction (x) of the connection layer (20),
wherein at least one of the first width (xₐ) is between 20µm and 500µm, and the second width (x_{b}) is between 20µm and 500µm, and
wherein the porosity of the first regions (a) is more than 5% lower than the porosity of the second regions (b).

2. The semiconductor substrate (10) arrangement of claim 1, wherein the first regions (a) alternate with the second regions (b) in at least one horizontal direction of the semiconductor substrate (10), wherein a horizontal direction of the semiconductor substrate (10) is a direction parallel to a top surface of the semiconductor substrate (10).

3. The semiconductor substrate (10) arrangement of claim 2, wherein the alternating first and second regions (a, b) form a periodic pattern.

4. The semiconductor substrate (10) arrangement of claim 3, wherein the periodic pattern is a grid pattern.

5. The semiconductor substrate (10) arrangement of any of the preceding claims, wherein at least one of
the first regions (a) have a first porosity of 20% or lower, 15% or lower, or 10% or lower; and
the second regions (b) have a second porosity of more than 10%, more than 20%, more than 40% or more than 50%.

6. The semiconductor substrate (10) arrangement of any of the preceding claims, wherein the connection layer (20) has a thickness of between 1 µm and 80 µm.

7. The semiconductor substrate (10) arrangement of any of the preceding claims, wherein each of the plurality of first regions (a) has a square shape, a rectangular shape, or a diamond shape.

8. The semiconductor substrate (10) arrangement of any of the preceding claims, wherein
each of the plurality of second regions (b) is an elongated region; and
the plurality of second regions (b) are configured to separate the individual first regions (a) from one another.

9. The semiconductor substrate (10) arrangement of claim 8, wherein
the length of each of a first number (b₁) of second regions (b) is 10 times, 100 times or 1.000 times larger than the width (x_{b}) of the respective second region (bi), and
the width (x_{b}) of each of a second number (b₂) of second regions (b) is 10 times, 100 times or 1.000 times larger than the length of the respective second region (b₂).

10. A method comprising:
applying a pre-layer (21) having a wavy profile to a first surface or to a second surface of a semiconductor substrate (10), wherein the semiconductor substrate (10) comprises an electrically insulating layer (11), a first metallization layer (111) on a first side of the electrically insulating layer (111), and a second metallization layer (112) on a second side of the electrically insulating layer (11), wherein the dielectric insulation layer (11) is disposed between the first and the second metallization layer (111, 112); and
mounting a component (30, 31) to the pre-layer (21),
wherein mounting the component (30, 31) to the pre-layer (21) comprises applying pressure to the component (30, 31) and the pre-layer (21), thereby leveling the pre-layer (21) such that a plane connection layer (20) is formed between the semiconductor substrate (10) and the component (30, 31),
wherein the connection layer (20) comprises a plurality of first regions (a) having a first porosity and a plurality of second regions (b) having a second porosity,
wherein the first porosity is different from the second porosity,
wherein each first region (a) has a first width (xₐ) in a first horizontal direction (x) of the connection layer (20), and each second region (b) has a second width (x_{b}) in the first horizontal direction (x) of the connection layer (20),
wherein at least one of the first width (xₐ) is between 20µm and 500µm, and the second width (x_{b}) is between 20µm and 500µm, and
wherein the porosity of the first regions (a) is more than 5% lower than the porosity of the second regions (b).

11. The method of claim 10, wherein applying a pre-layer (21) to the first surface of the semiconductor substrate (10) comprises applying a liquid, viscous or wax-like paste (22) to the first surface of the semiconductor substrate (10).

12. The method of claim 11, wherein applying a pre-layer (21) to the first surface of the semiconductor substrate (10) further comprises covering some parts of the first surface with a screen (60) and leaving other parts of the first surface uncovered; and applying the paste (22) to those parts of the first surface which remain uncovered.

13. The method of claim 12, further comprising:
removing the screen (60) from the first surface; and
performing a drying step to remove liquid from the paste (22).
